# EUROPEAN PATENT APPLICATION

(11) **EP 3 550 343 A1**
(43) Date of publication of application: **09.10.2019**
(21) Application number: 19166757.5
(22) Date of filing: 02.04.2019
(51) Int. Cl.: G02B 6/42

(54) **OPTICAL CONNECTOR**

(30) Priority: 05.04.2018 JP 2018073415; 09.08.2018 JP 2018150793
(71) Applicant: YAZAKI CORPORATION, Minato-ku, Tokyo 108-8333 (JP)
(72) Inventor: HIKOSAKA, Tomohiro, Shizuoka (JP); NORO, Yuki, Tokyo (JP); MIYANARI, Motonori, Shizuoka (JP)
(74) Representative: Hoffmann Eitle

(57) **Abstract**

An optical connector includes a lens body, a photoelectric conversion module, and a housing. A light emitting side lens portion and a light receiving side lens portion are integrally formed on a substrate portion in the lens body. The photoelectric conversion module includes a light emitting element and a light receiving element disposed at positions facing the light emitting side lens portion and the light receiving side lens portion when combining the photoelectric conversion module with the lens body. The housing accommodates the photoelectric conversion module combined with the lens body. The lens body includes an optical path changing mechanism provided between the light emitting side lens portion and the light receiving side lens portion on the substrate portion, and changing at least an optical path of light from the light emitting side lens portion.

## Description

### [Technical Field]

The present invention relates to an optical connector.

### BACKGROUND OF THE INVENTION

### <Field of the Invention>

There has been known an optical connector used in the field of optical communication that includes a fiber optic transceiver (FOT) unit, a housing made of resin and holding the FOT unit (photoelectric conversion module), and a shield case fitted to an outer periphery of the housing (for example, see Patent Document 1: JP-A-2014-222256).

[Patent Document 1] JP-A-2014-222256

According to a related art, a FOT unit held in a housing may include a lens body in which a light emitting side lens portion and a light receiving side lens portion disposed at positions facing a light emitting element and a light receiving element are integrally formed. In an optical connector including such an FOT unit, a part of an optical signal incident on the light emitting side lens portion from the light emitting element becomes scattered light, leaks to the light receiving side and is received by the light receiving element, which may cause crosstalk.

### SUMMARY

One or more embodiments provide an optical connector excellent in optical transmission in which crosstalk is suppressed.

In an aspect (1), one or more embodiments provide an optical connector comprising a lens body, a photoelectric conversion module, and a housing. A light emitting side lens portion and a light receiving side lens portion are integrally formed on a substrate portion in the lens body. The photoelectric conversion module includes a light emitting element and a light receiving element disposed at positions facing the light emitting side lens portion and the light receiving side lens portion when combining the photoelectric conversion module with the lens body. The housing accommodates the photoelectric conversion module combined with the lens body. The lens body includes an optical path changing mechanism provided between the light emitting side lens portion and the light receiving side lens portion on the substrate portion, and changing at least an optical path of light from the light emitting side lens portion.

According to the optical connector having the aspect (1), the optical path changing mechanism for changing at least the optical path of the light from the light emitting side lens portion is provided between the light emitting side lens portion and the light receiving side lens portion of the substrate portion of the lens body. Therefore, light such as scattered light from the light emitting side lens portion can be guided in the substrate portion and suppressed from reaching the light receiving side lens portion. Thereby, it is possible to provide the optical connector excellent in optical transmission in which crosstalk caused by leakage of the optical signal from the light emitting element to the light receiving element is suppressed.

In an aspect (2), the optical path changing mechanism is a direct light optical path changing mechanism including a recessed portion or a through hole provided between the light emitting side lens portion and the light receiving side lens portion, and configured to change an optical path of direct light from the light emitting side lens portion toward the light receiving side lens portion.

According to the aspect (2), the optical path of the direct light directly heading from the light emitting side lens portion toward the light receiving side lens portion is changed by the direct light optical path changing mechanism configured by the recessed portion (recess or groove) or the through hole. That is, crosstalk due to direct light from the light emitting side lens portion being received by the light receiving element can be suppressed by forming the recessed portion or the through hole having a simple shape on the substrate portion.

In an aspect (3), at least an inner side surface of the recessed portion or the through hole at the light emitting side lens portion side includes an inclined surface inclined with respect to a surface orthogonal to a straight line passing through between the light emitting side lens portion and the light receiving side lens portion.

According to the aspect (3), the inner side surface on a light emitting side lens portion side of at least the recessed portion or the through hole is an inclined surface inclined with respect to the surface orthogonal to the straight line passing through the light emitting side lens portion and the light receiving side lens portion. Therefore, it is possible to reliably reflect the light from the light emitting side lens portion to a direction different from the direction toward the light receiving side lens portion by the inclined surface. Thereby, the effect of suppressing crosstalk can be improved.

In an aspect (4), the optical path changing mechanism includes a reflecting surface formed in a non-parallel manner with a straight line passing the light emitting side lens portion and the light receiving side lens portion. The optical path changing mechanism is an indirect light optical path changing mechanism configured to reflect an optical path of not direct light from the light emitting side lens portion toward the light receiving side lens portion by the reflecting surface and guide the light to a direction different from a direction toward the light receiving side lens portion.

According to the aspect (4), the light not directly travelling from the light emitting side lens portion toward the light receiving side lens portion may be reflected by the side surface or the like of the substrate portion and reach the light receiving side lens portion indirectly. However, the light can be suppressed from indirectly heading toward the light receiving side lens portion by providing the indirect light optical path changing mechanism including the reflecting surfaces not parallel to the straight line passing through the light emitting side lens portion and the light receiving side lens portion as the optical path changing mechanism. That is, it is possible to suppress crosstalk due to the indirect light from the light emitting side lens portion being received by the light receiving element.

In an aspect (5), the indirect light optical path changing mechanism includes a recessed portion formed in a side surface of the substrate portion between the light emitting side lens portion and the light receiving side lens portion. A bottom surface of the recessed portion is the reflecting surface.

According to the aspect (5), the indirect light from the light emitting side lens portion can be suppressed from heading toward the light receiving side lens portion by the reflecting surface configured by the bottom surface of the recessed portion formed on the side surface of the substrate portion between the light emitting side lens portion and the light receiving side lens portion. Accordingly, it is possible to suppress crosstalk due to the indirect light from the light emitting side lens portion being received by the light receiving element. Further, the sectional area between the light emitting side lens portion and the light receiving side lens portion is decreased by forming the recessed portion, and the crosstalk is further suppressed.

According to the aspect (6), the indirect light optical path changing mechanism includes a recessed portion formed in at least one of a front surface and a rear surface of the substrate portion between the light emitting side lens portion and the light receiving side lens portion. An inner side surface of the recessed portion is the reflecting surface.

According to the aspect (6), the indirect light from the light emitting side lens portion can be suppressed from heading toward the light receiving side lens portion by the reflecting surface configured by the inner side surface of the recessed portion formed on at least one of the front surface and the rear surface of the substrate portion between the light emitting side lens portion and the light receiving side lens portion. Accordingly, it is possible to suppress crosstalk due to the indirect light from the light emitting side lens portion being received by the light receiving element.

According to one or more embodiments, it is possible to provide an optical connector excellent in optical transmission in which crosstalk is suppressed.

The present invention has been briefly described as above. Further, details of the present invention will be clarified by reading a mode for implementing the present invention to be described below with reference to the accompanying drawings.

### BRIEF DESCRIPTION OF THE DRAWINGS

Fig. 1 is a perspective view of an optical connector according to a first embodiment and a mating side optical connector.
Fig. 2 is a perspective view of the mating side optical connector shown in Fig. 1.
Fig. 3 is an exploded perspective view of the optical connector shown in Fig. 1.
Figs. 4A and 4B are views for explaining the optical connector shown in Fig. 1. Fig. 4A is a perspective view of the optical connector as seen from a rear side. Fig. 4B is a perspective view of a housing and a shield case as seen from the rear side.
Figs. 5A and 5B are views for explaining an optical module housing portion of the housing shown in Figs. 4A and 4B. Fig. 5A is a perspective view of a photoelectric conversion module and the housing to which a lens body is attached as seen from the rear side. Fig. 5B is a perspective view of the housing, the lens body and the photoelectric conversion module as seen from the rear side.
Fig. 6 is a perspective view of the lens body and the photoelectric conversion module in an assembled state as seen from the rear side.
Figs. 7A and 7B are views for explaining the lens body and the photoelectric conversion module as shown in Fig. 6. Fig. 7A is a perspective view as seen from the rear side. Fig. 7B is a perspective view as seen from a front side.
Figs. 8A and 8B are views for explaining a direct light optical path changing mechanism and an indirect light optical path changing mechanism provided in the lens body shown in Figs. 7A and 7B. Fig. 8A is a perspective view as seen from a front side of the lens body. Fig. 8B is a perspective view as seen from a rear side of the lens body.
Fig. 9 is a front view of the lens body shown in Figs. 8A and 8B.
Fig. 10 is a sectional view taken along a line A-A in Fig. 9.
Fig. 11 is a front view of a center portion in a substrate portion of the lens body shown in Fig. 9.
Fig. 12 is a front view of a center portion in a substrate portion of a lens body according to a reference example.
Figs. 13A and 13B are views for explaining a direct light optical path changing mechanism and an indirect light optical path changing mechanism provided in a lens body of an optical connector according to a second embodiment. Fig. 13A is a perspective view as seen from a front side of the lens body. Fig. 13B is a perspective view as seen from a rear side of the lens body.
Fig. 14 is a front view of the lens body shown in Figs. 13A and 13B.

### DETAILED DESCRIPTION

Hereinafter, embodiments according to the present invention will be described with reference to the drawings.

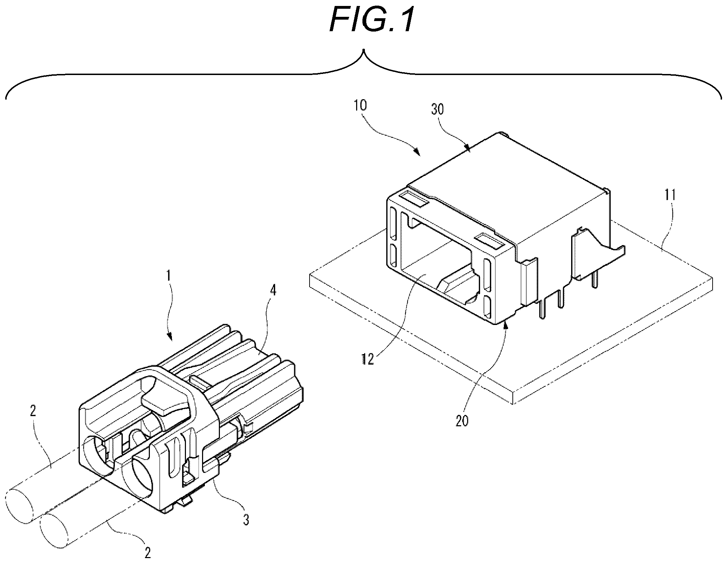

Fig. 1 is a perspective view of an optical connector 10 according to a first embodiment of the present invention and a mating side optical connector 1.

As shown in Fig. 1, an optical connector 10 according to the first embodiment is a receptacle optical connector to which a mating side optical connector 1 as a plug connector is fitted. The optical connector 10 is mounted on a circuit board 11, and the mating side optical connector 1 is fitted into a fitting recessed portion 12 in the optical connector 10.

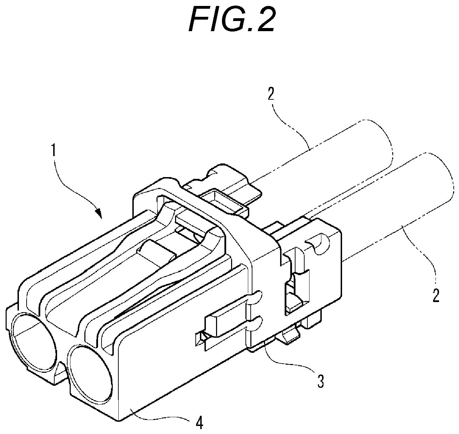

Fig. 2 is a perspective view of the mating side optical connector 1 shown in Fig. 1.

As shown in Fig. 2, the mating side optical connector 1 includes a housing 3 connected to an end portion of an optical fiber 2. A front end of the housing 3 is a fitting portion 4, and the fitting portion 4 is fitted into the fitting recessed portion 12 of the optical connector 10. Accordingly, the optical connector 10 and the optical fiber 2 of the mating side optical connector 1 can be brought into optical communication.

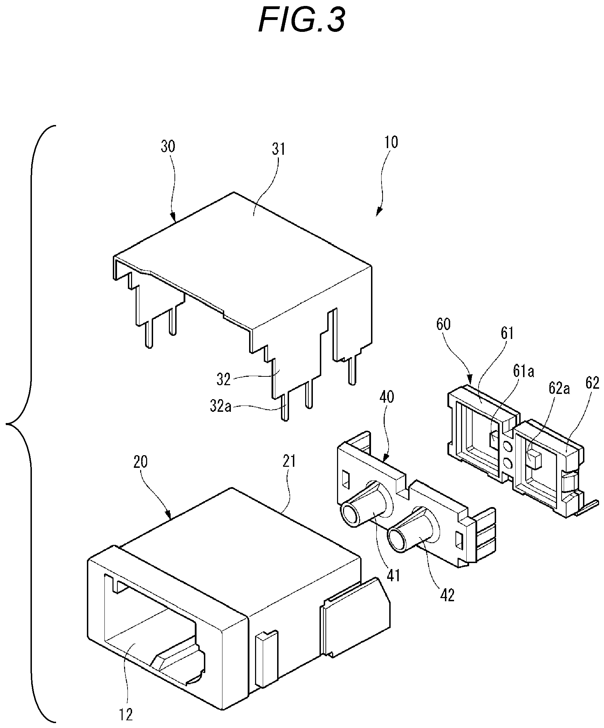

Fig. 3 is an exploded perspective view of the optical connector 10 shown in Fig. 1.

As shown in Fig. 3, the optical connector 10 includes a housing 20, a shield case 30, a lens body 40, and a fiber optic transceiver (FOT) 60 that is a photoelectric conversion module.

The housing 20 is a member having a box shape and molded from synthetic resin. The housing 20 is formed with the fitting recessed portion 12 into which the fitting portion 4 of the mating optical connector 1 is fitted on a front end side. The housing 20 is provided with a ferrule (not shown) therein, and the end portion of the optical fiber 2 of the mating side optical connector 1 fitted in the fitting recessed portion 12 is fitted into the ferrule. The housing 20 includes an optical module housing portion 21 on a rear end side, and the lens body 40 and the FOT 60 are assembled in the optical module housing portion 21. In addition, the shield case 30 is fitted with and mounted on the housing 20 from the top. A plurality of protruding portions (not shown) are formed on a lower portion of the housing 20. The protruding portions are fitted into holes formed in the circuit board 11, so that the optical connector 10 is positioned when being mounted on the circuit board 11.

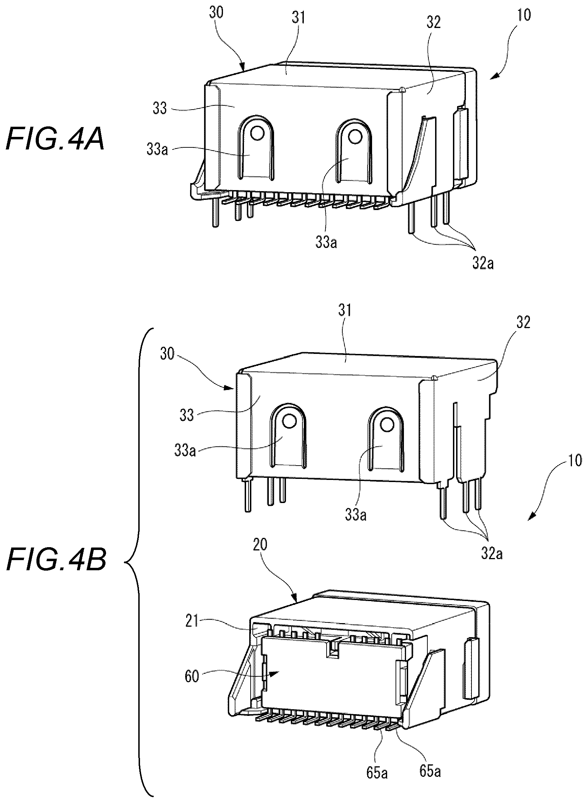

Figs. 4A and 4B are views for explaining the optical connector 10 shown in Fig. 1. Fig. 4A is a perspective view of the optical connector 10 as seen from a rear side. Fig. 4B is a perspective view of the housing 20 and the shield case 30 as seen from the rear side.

As shown in Figs. 4A and 4B, the shield case 30 is formed into a box shape and includes a top plate portion 31, side plate portions 32 formed on both sides of the top plate portion 31, and a rear plate portion 33 formed on a rear side of the top plate portion 31. The shield case 30 is formed into a box shape by pressing a conductive metal plate or the like. The shield case 30 is attached to the housing 20 so as to cover and shield an upper portion, both side portions, and a rear portion of the housing 20. A plurality of leg portions 32a are formed on the side plate portions 32, and the leg portions 32a are inserted and soldered into through holes (not shown) of the circuit board 11. Accordingly, the optical connector 10 is fixed to the circuit board 11. Further, the rear plate portion 33 includes plate spring portions 33a protruding inward. The plate spring portions 33a press a rear surface of the FOT 60 accommodated in the optical module housing portion 21 of the housing 20. Accordingly, the lens body 40 and the FOT 60 accommodated in the optical module housing portion 21 of the housing 20 are maintained in a state of being held in the housing 20 by an urging force of the plate spring portions 33a.

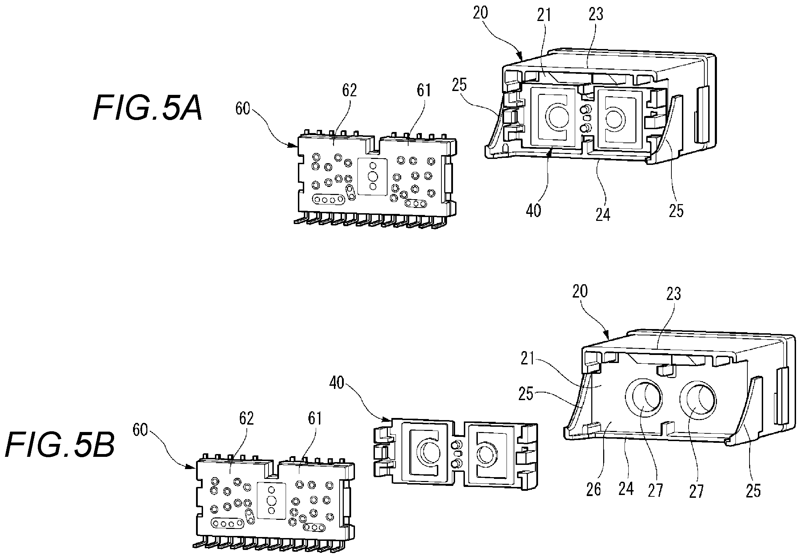

Figs. 5A and 5B are views for explaining the optical module housing portion 21 of the housing 20 shown in Figs. 4A and 4B. Fig. 5A is a perspective view of the FOT 60 and the housing 20 to which the lens body 40 is attached as seen from the rear side. Fig. 5B is a perspective view of the housing 20, the lens body 40 and the FOT 60 as seen from the rear side.

As shown in Figs. 5A and 5B, the lens body 40 and the FOT 60 are assembled in the optical module housing portion 21 on the rear end side of the housing 20. The optical module housing portion 21 is formed in a recessed shape into which the lens body 40 and the FOT 60 are fitted. The optical module housing portion 21 includes an upper wall portion 23, a bottom wall portion 24, and a pair of side wall portions 25. In addition, a bottom portion of the recessed part of the optical module housing portion 21 is a contact surface 26, and two lens insertion holes 27 are formed in the contact surface 26.

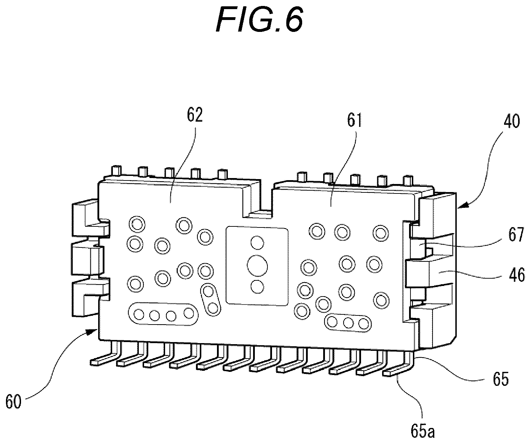

Fig. 6 is a perspective view of the lens body 40 and the FOT 60 in an assembled state as seen from the rear side. As shown in Fig. 6, the lens body 40 and the FOT 60 are combined with each other so as to be positioned. The lens body 40 and the FOT 60 are assembled to the optical module housing portion 21 of the housing 20 in a state of being combined with each other. Thereby, the FOT 60 is positioned with respect to the housing 20.

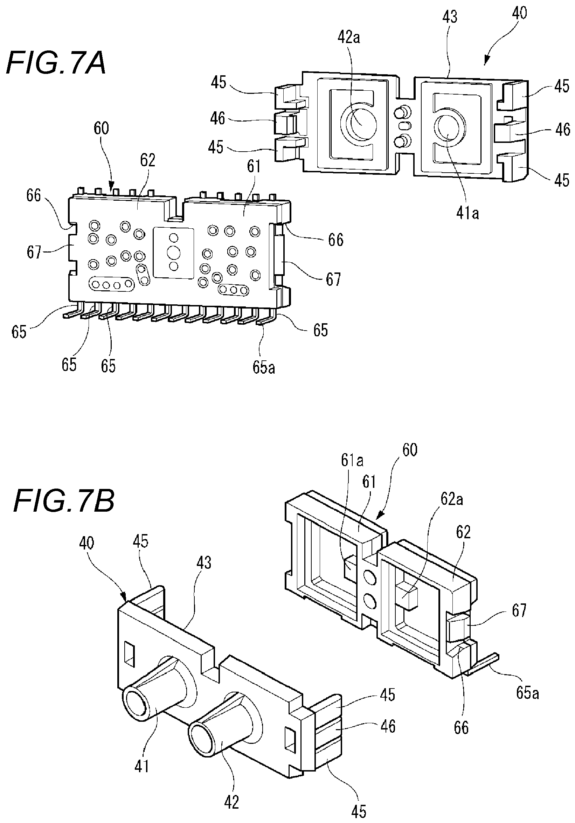

Figs. 7A and 7B are views for explaining the lens body 40 and the FOT 60 as shown in Fig. 6. Fig. 7A is a perspective view as seen from the rear side. Fig. 7B is a perspective view as seen from a front side.

As shown in Figs. 7A and 7B, the lens body 40 includes a substrate portion 43 formed in a rectangular shape in the plan view, and a light emitting side lens portion 41 and a light receiving side lens portion 42 are formed on the substrate portion 43. The light emitting side lens portion 41 and the light receiving side lens portion 42 are provided side by side. The lens body 40 is integrally formed of transparent resin having light guiding properties, so that the light emitting side lens portion 41 and the light receiving side lens portion 42 are integrally provided to protrude forward from a front surface of the substrate portion 43. An FOT 60 side of the light emitting side lens portion 41 is an incident surface 41a, and an FOT 60 side of the light receiving side lens portion 42 is an emitting surface 42a. The lens body 40 is formed with engagement protrusions 45 and locking claws 46 on both sides of the substrate portion 43. The engagement protrusions 45 are provided on both sides of the locking claw 46.

The FOT 60 is formed in a rectangular shape in the plan view, and a light emitting side FOT 61 and a light receiving side FOT 62 are provided side by side on a front surface of the FOT 60. The light emitting side FOT 61 includes a light emitting element 61a such as a light emitting diode (LED), a vertical cavity surface emitting laser (VCSEL), for example, and the light receiving side FOT 62 includes a light receiving element 62a such as a photo diode (PD), for example. The FOT 60 is integrally formed of synthetic resin, so that the light emitting side FOT 61 and the light receiving side FOT 62 are integrally provided. A plurality of lead frames 65 are provided at a lower portion of the FOT 60. The lead frame 65 includes a connection portion 65a whose end portion is bent toward the rear side of the FOT 60. The connection portion 65a is disposed and soldered on a pad of the circuit board 11 so as to be electrically connected to a predetermined circuit of the circuit board 11. Recessed portions 66 are formed on both sides of the FOT 60, and a locking piece 67 is provided in the recessed portion 66 and protruding therefrom.

The FOT 60 is assembled to the rear surface side having the incident surface 41a and the emitting surface 42a of the lens body 40. At this time, the engagement protrusions 45 of the lens body 40 are engaged with the recessed portion 66 of the FOT 60, and the locking claw 46 of the lens body 40 is locked with the locking piece 67 of the FOT 60. Accordingly, the FOT 60 is assembled to the lens body 40, and the light emitting element 61a of the light emitting side FOT 61 and the light receiving element 62a of the light receiving side FOT 62 in the FOT 60 are disposed at positions facing the incident surface 41a of the light emitting side lens portion 41 and the emitting surface 42a of the light receiving side lens portion 42 in the lens body 40, respectively.

The assembly of the lens body 40 and the FOT 60 is fitted in the optical module housing portion 21 of the housing 20 and accommodated in a state of being positioned at a predetermined position. As a result, the light emitting side lens portion 41 and the light receiving side lens portion 42 of the lens body 40 are inserted into the lens insertion holes 27 of the housing 20, and a front surface of the lens body 40 is brought into contact with the contact surface 26. Accordingly, the light emitting side lens portion 41 and the light receiving side lens portion 42 of the lens body 40 are accommodated in the lens insertion holes 27 in a state of being positioned on the ferrule inside the housing 20.

Further, when the shield case 30 is attached to the housing 20, the FOT 60 is pressed by the plate spring portions 33a formed on the rear plate portion 33 of the shield case 30. Therefore, the lens body 40 and the FOT 60 are maintained in a state of being held in the optical module housing portion 21 of the housing 20.

In the optical connector 10, an optical signal converted and generated from an electrical signal by the light emitting side FOT 61 of the FOT 60 is incident on the light emitting side lens portion 41 of the lens body 40 from the incident surface 41a and is guided to one optical fiber 2 of the mating side optical connector 1 fitted to the fitting recessed portion 12. In addition, an optical signal incident on the light receiving side lens portion 42 from the other optical fiber 2 of the mating side optical connector 1 is emitted from the emitting surface 42a of the light receiving side lens portion 42 of the lens body 40, received by the light receiving side FOT 62 of the FOT 60, and converted into an electrical signal.

Incidentally, in the optical connector 10, a part of the optical signal incident on the light emitting side lens portion 41 of the lens body 40 from the light emitting side FOT 61 of the FOT 60 is guided to the substrate portion 43 as scattered light. The scattered light may travel directly to the substrate portion 43 or may be reflected on the surrounding surface to reach the light receiving side lens portion 42. Then, the light reaching the light receiving side lens portion 42 is received by the light receiving side FOT 62 of the FOT 60, which may cause crosstalk.

Therefore, in order to suppress the crosstalk between the light emitting side FOT 61 and the light receiving side FOT 62, the optical connector 10 according to the first embodiment is provided with a direct light optical path changing mechanism and an indirect light optical path changing mechanism on the lens body 40.

Next, the direct light optical path changing mechanism and the indirect light optical path changing mechanism provided on the lens body 40 of the optical connector 10 will be described.

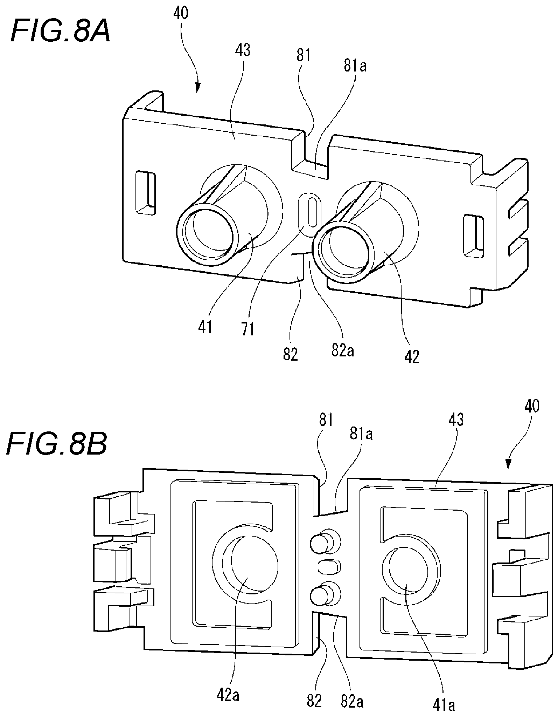

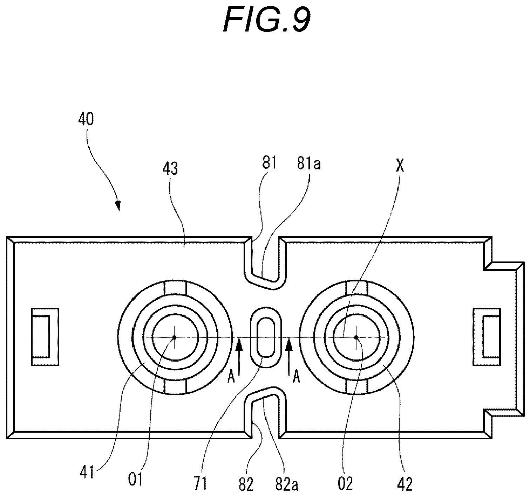

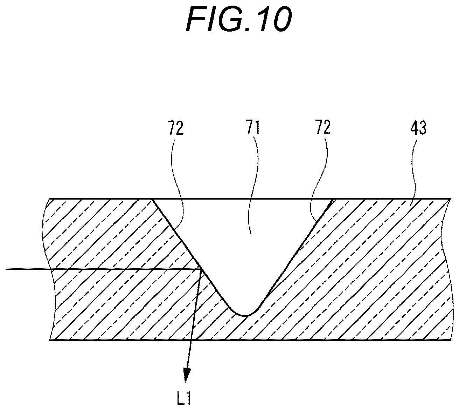

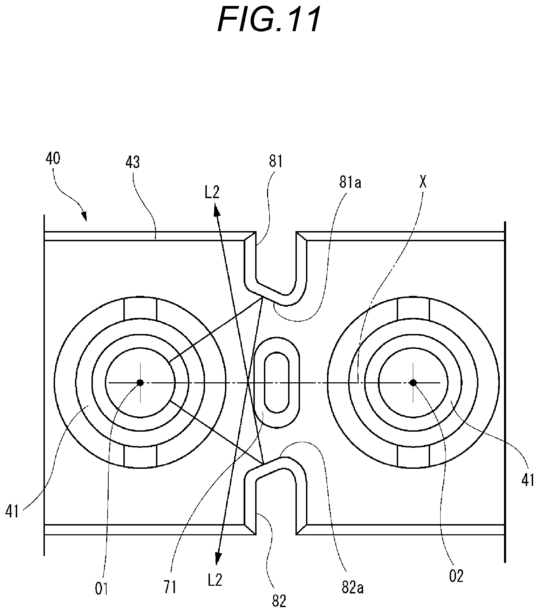

Figs. 8A and 8B are views for explaining the direct light optical path changing mechanism and the indirect light optical path changing mechanism provided in the lens body 40 shown in Figs. 7A and 7B. Fig. 8A is a perspective view as seen from a front side of the lens body 40. Fig. 8B is a perspective view as seen from a rear side of the lens body 40. Fig. 9 is a front view of the lens body 40 shown in Figs. 8A and 8B. Fig. 10 is a sectional view taken along a line A-A in Fig. 9. Fig. 11 is a front view of a center portion in a substrate portion 43 of the lens body 40 shown in Fig. 9.

### (Direct Light Optical Path Changing Mechanism)

As shown in Figs. 8A and 9, a recessed portion 71 is formed in the substrate portion 43 of the lens body 40, and the recessed portion 71 serves as a direct light optical path changing mechanism. The recessed portion 71 is an oblong recess that is formed on a front surface side of the substrate portion 43 of the lens body 40 and extends in a vertical direction as seen from the front side. The recessed portion 71 is formed between the light emitting side lens portion 41 and the light receiving side lens portion 42, and is disposed at a position crossing a straight line X passing through the center O1 of the light emitting side lens portion 41 and the center O2 of the light receiving side lens portion 42. As shown in Fig. 10, an inner side surface 72 of the recessed portion 71 is an inclined surface inclined with respect to a surface orthogonal to the straight line X.

### (Indirect Light Optical Path Changing Mechanism)

As shown in Figs. 8A, 8B and 9, recessed portions 81, 82 are formed on a side surface of the substrate portion 43 at an upper portion and a lower portion in the lens body 40. The recessed portions 81, 82 are formed between the light emitting side lens portion 41 and the light receiving side lens portion 42 in the substrate portion 43. Bottom surface portions of the recessed portions 81, 82 serve as reflecting surfaces 81a, 82a. The reflecting surfaces 81a, 82a are gradually inclined toward the center from the light emitting side lens portion 41 toward the light receiving side lens portion 42 separately. That is, the reflecting surfaces 81a, 82a are not parallel to the straight line X passing through the center O1 of the light emitting side lens portion 41 and the center O2 of the light receiving side lens portion 42. The reflecting surfaces 81a, 82a serve as the indirect light optical path changing mechanism.

Next, the change of an optical path by the direct light optical path changing mechanism and the indirect light optical path changing mechanism will be described.

In the optical connector 10, a part of the optical signal incident on the incident surface 41a of the light emitting side lens portion 41 of the lens body 40 from the light emitting side FOT 61 of the FOT 60 is guided to the substrate portion 43 as scattered light. A part of the scattered light L1 travels directly toward the light receiving side lens portion 42. As shown in Fig. 10, when the light L1 reaches the recessed portion 71 serving as the direct light optical path changing mechanism and formed between the light emitting side lens portion 41 and the light receiving side lens portion 42, the light L1 is reflected by the inner side surface 72 of the recessed portion 71 and guided to the outside of the substrate portion 43 without heading toward the light receiving side lens portion 42.

Further, as shown in Fig. 11, the other part of the scattered light incident on the substrate portion 43 becomes light L2 that does not travel directly to the light receiving side lens portion 42 but heads toward the upper portion or the lower portion of the substrate portion 43. The light L2 reaches and reflected by the indirect light optical path changing mechanism including the reflecting surfaces 81a, 82a of the recessed portions 81, 82 formed on the side surface of the substrate portion 43 at the upper portion and lower portion. Since the reflecting surfaces 81a, 82a are not parallel to the straight line X passing through the center O1 of the light emitting side lens portion 41 and the center O2 of the light receiving side lens portion 42, the light L2 reflected by the reflecting surfaces 81a, 82a is guided to the outside of the substrate portion 43 without heading toward the light receiving side lens portion 42. That is, the light L2 from the light emitting side lens portion 41 is reflected by the reflecting surfaces 81a, 82a, so that the optical path of the light L2 in the lens body 40 is asymmetric. Therefore, in the lens body 40, the light L2 incident on the substrate portion 43 from the light emitting side lens portion 41 is suppressed from indirectly traveling to the light receiving side lens portion 42 through optical paths symmetrical between the light emitting side lens portion 41 and the light receiving side lens portion 42.

As described above, according to the optical connector 10 of the first embodiment, the direct light optical path changing mechanism and the indirect light optical path changing mechanism for changing an optical path of light are provided between the light emitting side lens portion 41 and the light receiving side lens portion 42 of the substrate portion 43 of the lens body 40. Therefore, light such as scattered light from the light emitting side lens portion 41 can be guided in the substrate portion 43 and suppressed from reaching the light receiving side lens portion 42. Thereby, it is possible to provide the optical connector 10 excellent in optical transmission in which crosstalk caused by leakage of the optical signal from the light emitting side FOT 61 to the light receiving side FOT 62 is suppressed.

Specifically, the optical path of the direct light directly heading from the light emitting side lens portion 41 toward the light receiving side lens portion 42 is changed by the direct light optical path changing mechanism configured by the recessed portion 71. That is, crosstalk due to direct light from the light emitting side lens portion 41 being received by the light receiving side FOT 62 can be suppressed by forming the recessed portion 71 having a simple shape on the substrate portion 43.

Particularly, the inner side surface 72 of the recessed portion 71 is an inclined surface inclined with respect to the surface orthogonal to the straight line X passing through the light emitting side lens portion 41 and the light receiving side lens portion 42. Therefore, it is possible to reliably reflect the light from the light emitting side lens portion 41 to a direction different from the direction toward the light receiving side lens portion 42 by the inner side surface 72 configured by the inclined surface. Thereby, the effect of suppressing crosstalk can be improved.

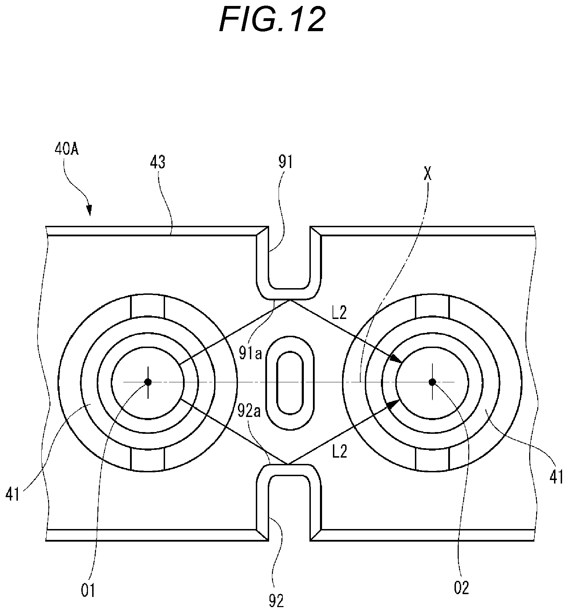

As described above, the light not directly travelling from the light emitting side lens portion 41 toward the light receiving side lens portion 42 may be reflected by the side surface or the like of the substrate portion 43 and reach the light receiving side lens portion 42 indirectly. For example, Fig. 12 shows a lens body 40A in which recessed portions 91, 92 whose bottom surfaces are reflecting surfaces 91a, 92a are formed on the substrate portion 43, the reflecting surfaces 91a, 92a being parallel to the straight line X passing through the light emitting side lens portion 41 and the light receiving side lens portion 42. In the lens body 40A, the light L2 not directly travelling from the light emitting side lens portion 41 toward the light receiving side lens portion 42 is reflected by the reflecting surfaces 91a, 92a and reaches the light receiving side lens portion 42, thereby causing crosstalk.

In the first embodiment, the light can be suppressed from indirectly heading toward the light receiving side lens portion 42 by providing the indirect light optical path changing mechanism including the reflecting surfaces 81a, 82a not parallel to the straight line X passing through the light emitting side lens portion 41 and the light receiving side lens portion 42 as the optical path changing mechanism. That is, it is possible to suppress crosstalk due to the indirect light from the light emitting side lens portion 41 being received by the light receiving side FOT 62.

Further, the recessed portions are formed in the side surface of the substrate portion 43 between the light emitting side lens portion 41 and the light receiving side lens portion 42, so that a sectional area between the light emitting side lens portion 41 and the light receiving side lens portion 42 decreases, and crosstalk is further suppressed.

Incidentally, in the optical connector 10, it is also possible to change an optical path of light incident on the light receiving side lens portion 42 from the optical fiber 2 and heading toward the light emitting side lens portion 41. Therefore, it is also possible to suppress the influence of the light from the light receiving side lens portion 42 on the light emitting side FOT 61 having the light emitting element 61a.

Incidentally, the present invention is not limited to the above-described embodiment, but may be appropriately modified, improved or the like. In addition, materials, shapes, dimensions, numerals, disposition locations or the like of each constituent element in the above-described embodiment are optional are not limited as long as the object of the invention can be achieved.

For example, in the first embodiment, the recessed portion 71 configured by the recess is formed in the substrate portion 43 as the direct light optical path changing mechanism for changing an optical path of direct light, and a groove or a through hole formed on the substrate portion 43 may also serve as the direct light optical path changing mechanism. In this case, the optical path of the direct light can be changed by an inner side surface of the groove or the through hole, so as to be suppressed from reaching the light receiving side lens portion 42. Further, in the first embodiment, the reflecting surfaces 81a, 82a are formed on the bottom surfaces of the recessed portions 81, 82 formed in the side surface of the substrate portion 43 as the indirect light optical path changing mechanism, and the reflecting surface formed on an inner side surface of the recessed portion (recess or groove) formed on at least the front surface or the rear surface of the substrate portion 43 may also serve as the indirect light optical path changing mechanism.

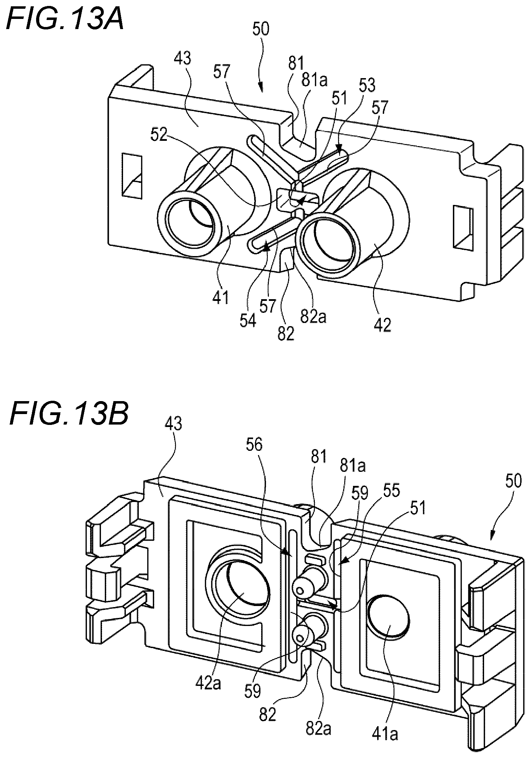

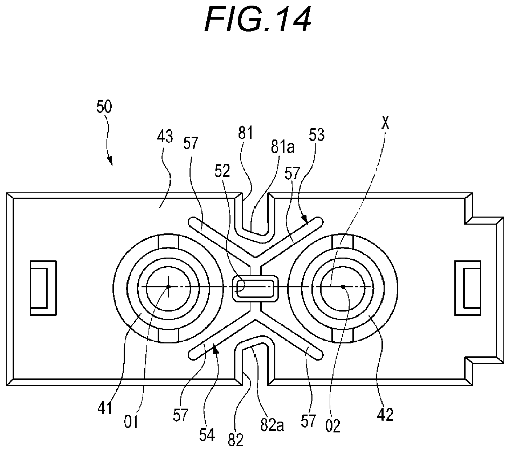

Figs. 13A and 13B are views for explaining a direct light optical path changing mechanism and an indirect light optical path changing mechanism provided in a lens body 50 of an optical connector according to a second embodiment of the present invention. Fig. 13A is a perspective view as seen from a front side of the lens body 50. Fig. 13B is a perspective view as seen from a rear side of the lens body 50. Fig. 14 is a front view of the lens body 50 shown in Figs. 13A and 13B.

### (Direct Light Optical Path Changing Mechanism)

As shown in Figs. 13A and 14, a rectangular through hole 51 elongated in a left-right direction is formed in the substrate portion 43 of the lens body 50. The through hole 51, as the direct light optical path changing mechanism, is formed between the light emitting side lens portion 41 and the light receiving side lens portion 42, and is disposed at a position crossing a straight line X passing through the center O1 of the light emitting side lens portion 41 and the center O2 of the light receiving side lens portion 42. Further, an inner side surface 52 of the through hole 51 is an inclined surface inclined with respect to a surface orthogonal to the straight line X.

### (Indirect Light Optical Path Changing Mechanism)

As shown in Fig. 13B, on the rear surface of the substrate portion 43, a pair of grooves 55, 56 parallel to each other and extending upward and downward from both end portions in a longitudinal direction of the through hole 51 are formed as recessed portions serving as an indirect light optical path changing mechanism. The groove 55 is formed between the light emitting side lens portion 41 and the through hole 51, and the groove 56 is formed between the light receiving side lens portion 42 and the through hole 51. The inner side surfaces of the grooves 55, 56 serve as a reflecting surface 59. The reflecting surface 59 is an inclined surface inclined with respect to the rear surface of the substrate portion 43.

Further, as shown in Figs. 13A and 14, on the front surface of the substrate portion 43 in the lens body 50, substantially Y-shaped grooves 53, 54 separately extending upward and downward from a center portion of the through hole 51 are formed as recessed portions serving as the indirect light optical path changing mechanism. The grooves 53, 54 are formed between the light emitting side lens portion 41 and the light receiving side lens portion 42 in the substrate portion 43. The inner side surfaces of the grooves 53, 54 serve as a reflecting surface 57. The reflecting surface 57 is an inclined surface inclined with respect to the front surface of the substrate portion 43.

Next, the change of an optical path by the direct light optical path changing mechanism and the indirect light optical path changing mechanism provided on the lens body 50 of the optical connector according to the second embodiment will be described.
A part of an optical signal incident on the incident surface 41a of the light emitting side lens portion 41 of the lens body 50 is guided to the substrate portion 43 as scattered light. A part of the scattered light travels directly toward the light receiving side lens portion 42. Further, when the light reaches the through hole 51 serving as the direct light optical path changing mechanism and formed between the light emitting side lens portion 41 and the light receiving side lens portion 42, the light is reflected by an inner side surface 52 of the through hole 51 and guided to the outside of the substrate portion 43 without heading toward the light receiving side lens portion 42.

Further, the other part of the scattered light incident on the substrate portion 43 becomes light that does not travel directly toward the light receiving side lens portion 42 but heads toward the upper portion or the lower portion of the substrate portion 43 (see Fig. 11). The light reaches and reflected by the indirect light optical path changing mechanism including the reflecting surface 57 formed on the inner side surface of the grooves 53, 54 formed on the front surface of the substrate portion 43, and the reflecting surface 59 formed on the inner side surface of the grooves 55, 56 formed on the rear surface of the substrate portion 43. Since the reflecting surface 57 and the reflecting surface 59 are inclined surfaces inclined with respect to the front surface or the rear surface of the substrate portion 43, the light reflected by the reflecting surface 57 and the reflecting surface 59 is guided to the outside of the substrate portion 43 without heading toward the light receiving side lens portion 42. That is, the light from the light emitting side lens portion 41 is reflected by the reflecting surface 57 and reflecting surface 59, so as to be suppressed from indirectly heading toward the light receiving side lens portion 42.

As described above, similarly to the lens body 40 of the optical connector according to the first embodiment, according to the lens body 50 of the optical connector of the second embodiment, the optical path of the direct light directly heading from the light emitting side lens portion 41 toward the light receiving side lens portion 42 is changed by the direct light optical path changing mechanism configured by the through hole 51. That is, crosstalk due to direct light from the light emitting side lens portion 41 being received by the light receiving side FOT 62 can be suppressed by forming the through hole 51 having a simple shape on the substrate portion 43.

Further, the light not directly travelling from the light emitting side lens portion 41 toward the light receiving side lens portion 42 can be suppressed from indirectly heading toward the light receiving side lens portion 42 by the reflecting surface 57 of the grooves 53, 54 and the reflecting surface 59 of the grooves 55, 56 which are serving as the indirect light optical path changing mechanism. That is, it is possible to suppress crosstalk due to the indirect light from the light emitting side lens portion 41 being received by the light receiving side FOT 62.

Here, characteristics of the embodiments of the optical connector according to the present invention described above are summarized briefly in the following [1] to [6], respectively.
[1] An optical connector (10) comprising:
   a lens body (40);
   a photoelectric conversion module (FOT 60); and
   a housing (20),
   wherein a light emitting side lens portion (41) and a light receiving side lens portion (42) are integrally formed on a substrate portion (43) in the lens body (40),
   wherein the photoelectric conversion module (FOT 60) includes a light emitting element (61a) and a light receiving element (62a) disposed at positions facing the light emitting side lens portion (41) and the light receiving side lens portion (42) when combining the photoelectric conversion module with the lens body (40),
   wherein the housing (20) accommodates the photoelectric conversion module (FOT 60) combined with the lens body (40), and
   wherein the lens body (40) includes an optical path changing mechanism provided between the light emitting side lens portion (41) and the light receiving side lens portion (42) on the substrate portion (43) and changing at least an optical path of light from the light emitting side lens portion (41).
[2] The optical connector (10) according to the above-described [1],
   wherein the optical path changing mechanism is a direct light optical path changing mechanism including a recessed portion (71) or a through hole (51) provided between the light emitting side lens portion (41) and the light receiving side lens portion (42) on the substrate portion (43), and configured to change an optical path of direct light from the light emitting side lens portion (41) toward the light receiving side lens portion (42).
[3] The optical connector (10) according to the above-described [2],
   wherein at least an inner side surface (72, 52) of the recessed portion (71) or the through hole (51) at the light emitting side lens portion (41) side includes an inclined surface inclined with respect to a surface orthogonal to a straight line (X) passing through between the light emitting side lens portion (41) and the light receiving side lens portion (42).
[4] The optical connector (10) according to the above-described [1],
   wherein the optical path changing mechanism includes a reflecting surface (81a, 82a, 57, 59) formed in a non-parallel manner with a straight line (X) passing the light emitting side lens portion (41) and the light receiving side lens portion (42), and
   wherein the optical path changing mechanism is an indirect light optical path changing mechanism configured to reflect an optical path of not direct light from the light emitting side lens portion (41) toward the light receiving side lens portion (42) by the reflecting surface (81a, 82a, 57, 59) and guide the light to a direction different from a direction toward the light receiving side lens portion (42).
[5] The optical connector (10) according to the above-described [4],
   wherein the indirect light optical path changing mechanism includes a recessed portion (81, 82) formed in a side surface of the substrate portion (43) between the light emitting side lens portion (41) and the light receiving side lens portion (42), and
   wherein a bottom surface of the recessed portion (81, 82) is the reflecting surface (81a, 82a).
[6] The optical connector (10) according to the above-described [4],
   wherein the indirect light optical path changing mechanism includes a recessed portion (grooves 53, 54, grooves 55, 56) formed in at least one of a front surface and a rear surface of the substrate portion (43) between the light emitting side lens portion (41) and the light receiving side lens portion (42), and
   wherein an inner side surface of the recessed portion (grooves 53, 54, grooves 55, 56) is the reflecting surface (57, 59).

### [Description of Reference Numerals and Signs]

10 optical connector
20 housing
40 lens body
41 light emitting side lens portion
42 light receiving side lens portion
43 substrate portion
60 FOT (photoelectric conversion module)
61a light emitting element
62a light receiving element
71 recessed portion (direct light optical path changing mechanism)
72 inner side surface
81, 82 recessed portion
81a, 82a reflecting surface (indirect light optical path changing mechanism)
X straight line

## Claims

1. An optical connector comprising:
a lens body;
a photoelectric conversion module; and
a housing,
wherein a light emitting side lens portion and a light receiving side lens portion are integrally formed on a substrate portion in the lens body,
wherein the photoelectric conversion module includes a light emitting element and a light receiving element disposed at positions facing the light emitting side lens portion and the light receiving side lens portion when combining the photoelectric conversion module with the lens body,
wherein the housing accommodates the photoelectric conversion module combined with the lens body, and
wherein the lens body includes an optical path changing mechanism provided between the light emitting side lens portion and the light receiving side lens portion on the substrate portion, and changing at least an optical path of light from the light emitting side lens portion.

2. The optical connector according to claim 1,
wherein the optical path changing mechanism is a direct light optical path changing mechanism including a recessed portion or a through hole provided between the light emitting side lens portion and the light receiving side lens portion, and configured to change an optical path of direct light from the light emitting side lens portion toward the light receiving side lens portion.

3. The optical connector according to claim 2,
wherein at least an inner side surface of the recessed portion or the through hole at the light emitting side lens portion side includes an inclined surface inclined with respect to a surface orthogonal to a straight line passing through between the light emitting side lens portion and the light receiving side lens portion.

4. The optical connector according to claim 1,
wherein the optical path changing mechanism includes a reflecting surface formed in a non-parallel manner with a straight line passing the light emitting side lens portion and the light receiving side lens portion, and
wherein the optical path changing mechanism is an indirect light optical path changing mechanism configured to reflect an optical path of not direct light from the light emitting side lens portion toward the light receiving side lens portion by the reflecting surface and guide the light to a direction different from a direction toward the light receiving side lens portion.

5. The optical connector according to claim 4,
wherein the indirect light optical path changing mechanism includes a recessed portion formed in a side surface of the substrate portion between the light emitting side lens portion and the light receiving side lens portion, and
wherein a bottom surface of the recessed portion is the reflecting surface.

6. The optical connector according to claim 4,
wherein the indirect light optical path changing mechanism includes a recessed portion formed in at least one of a front surface and a rear surface of the substrate portion between the light emitting side lens portion and the light receiving side lens portion, and
wherein an inner side surface of the recessed portion is the reflecting surface.
